# EUROPÄISCHE PATENTSCHRIFT

(11) **EP 0 363 794 B1**
(45) Veröffentlichungstag und Bekanntmachung des Hinweises auf die Patenterteilung: **03.07.1996**
(21) Anmeldenummer: 89118360.0
(22) Anmeldetag: 04.10.1989
(51) Int. Cl.: B32B 31/00, B29C 70/34

(54) **Verfahren und Vorrichtung zur kontinuierlichen Herstellung von Laminaten**
Method and apparatus for the continuous production of laminates
Procédé et appareil pour fabriquer en continu des laminates

(30) Priorität: 14.10.1988 DE 3834993
(43) Veröffentlichungstag der Anmeldung: 18.04.1990
(73) Patentinhaber: Held, Kurt, D-78647 Trossingen (DE)
(72) Erfinder: Held, Kurt, D-78647 Trossingen (DE)

(56) Entgegenhaltungen:
- EP-A- 0 016 226
- EP-A- 0 027 543
- EP-A- 0 053 367
- EP-A- 0 088 978
- EP-A- 0 131 879
- EP-A- 0 203 368
- DE-C- 3 540 389
- DE-C- 3 712 576

## Beschreibung

Die Erfindung betrifft ein Verfahren zur kontinuierlichen Herstellung von Laminaten gemäß dem Oberbegriff des Patentanspruchs 1 und eine Vorrichtung zur Durchführung dieses Verfahrens gemäß dem Oberbegriff des Patentanspruchs 22.

Laminate oder Schichtstoffe bestehen aus mehreren Lagen von Materialbahnen, die mit einem duroplastischen Harz getränkt und in der gewünschten Reihenfolge aufeinandergeschichtet miteinander verpreßt sind. Als Materialbahnen werden Faser- oder Gewebebahnen verwendet. Bei den zur Imprägnierung dienenden duroplastischen Harzen handelt es sich um Melamin-, Harnstoff-, Phenol-, Epoxyharze oder dergleichen.

Solche Schichtstoffe werden beispielsweise als dekorativen Laminate zur Oberflächenbeschichtung von Spanplatten eingesetzt. Diese dekorativen Laminate bestehen aus einer Kern- und Oberflächenschicht, die sich wiederum aus melamin-oder phenolharzgetränkten Papieren zusammensetzt. Die auf der Kernschicht aufliegende Oberflächenschicht ist dabei mit einem Dekordruck, beispielsweise der Imitation einer Holzmaserung, versehen.

Technisch verwendete Schichtstoffe sind beispielsweise kupferkaschierte Laminate, die als Ausgangsmaterial für die Herstellung von Leiterplatten dienen. Solche kupferkaschierten Laminate bestehen beispielsweise aus einem Kern von mehreren Lagen von Glasgeweben, die mit einem Epoxyharz imprägniert sind. Auf den Oberflächen des Kerns und mit diesem verpreßt befindet sich eine elektrolytisch abgeschiedene Kupferfolie. Auch mit Phenolharz getränkte Papierlagen werden als Kernmaterial verwendet.

Es gibt auch Laminate, bei denen die einzelnen Lagen mit einem thermoplastischen Harz imprägniert sind. Diese Lagen werden in der gewünschten Reihenfolge aufeinandergeschichtet, erwärmt, miteinander verpreßt und anschließend wieder rückgekühlt. Während duroplastische Harze durch Wärme oder eine chemische Reaktion aushärten, härten thermoplastische Harze durch Kühlung aus.

Aus der DE-AS 27 22 262 ist ein Verfahren und eine Vorrichtung zur Herstellung von dekorativen Laminaten bekannt geworden. Bei diesem Verfahren werden unbeharzte Papiere von Rollen abgewickelt und anschließend durch eine Imprägniermaschine hindurchgeführt. In der Imprägniermaschine befindet sich ein bis zu einem gewissen Grade vorgehärtetes, duroplastisches Harz, das mit Hilfe von Lösungsmitteln und Wasser in flüssigem Zustand, dem sogenannten A-Zustand gehalten wird. In der Imprägniermaschine wird die Fasermatrix der Papierbahn mit dem Harz getränkt. Danach wird die harzgetränkte Papierbahn durch einen Trockentunnel hindurchgeführt, wo ein Teil des Lösungsmittels und des im Harz enthaltenen Wassers durch Wärmeeinwirkung aus der Papierbahn abgedunstet wird. Aufgrund der Wärmeeinwirkung härtet das Harz weiter bis maximal zum B-Zustand. Anschließend werden die Papierbahnen in der gewünschten Reihenfolge übereinandergeschichtet in eine Doppelbandpresse eingeführt und dort unter weiterer Wärmeeinwirkung miteinander verpreßt. In der Doppelbandpresse härtet das Harz schließlich bis zum C-Zustand aus und verbindet die einzelnen Schichten zum kompakten Laminat. Nach Verlassen der Doppelbandpresse wird die Laminatbahn gekühlt, geschliffen und anschließend auf Rollen aufgewickelt. Die in der Auslegeschrift gezeigte Vorrichtung besteht aus einer Doppelbandpresse, an deren Einlaufseite die Abwickeleinheiten für die Papierbahnen, die herkömmliche Imprägniermaschine und der Trockentunnel angeordnet sind.

Nachteilig bei dieser bekannten Vorrichtung ist, daß durch die Anordnung der der Verpressung vorgeschalteten Imprägnier- und Trockenprozesse vor der Doppelbandpresse die Gesamtlänge der Doppelbandpressenanlage stark vergrößert wird. Die die Imprägniermaschine verlassenden harzimprägnierten Papierbahnen sind sehr rißempfindlich und daher nur schwer auf der langen Strecke von den Abwickeleinrichtungen bis in den Einlauf der Doppelbandpresse zu steuern. Dieses bekannte, aufgrund der Einstufigkeit an sich wünschenswerte Verfahren hat sich daher nicht gegenüber dem zweistufigen Verfahren durchsetzen können, bei dem die Papierbahnen mit Harz imprägniert, getrocknet und anschließend wiederum auf Rollen aufgewickelt werden und erst in einem zweiten Schritt in der Doppelbandpresse zum Laminat verpreßt werden.

Weiter nachteilig bei diesem Verfahren ist, daß die Papierbahnen nach Verlassen der Imprägniermaschine stark klebrig sind und deshalb nicht weiter abgestützt und geführt werden können. Dadurch wird eine sehr starke Trocknung im Trockentunnel nötig, damit die Papierbahn ungestützt bis zum Einlauf in die Doppelbandpresse vorlaufen kann. Diese starke Erwärmung birgt jedoch die Gefahr der Weiterhärtung des Harzes über den B-Zustand hinaus in sich. Außerdem ist in der Doppelbandpresse eine weitere Erwärmung der beharzten Papierbahnen nötig, um das Harz wiederum schmelzflüssig zu machen, damit eine gute Verbindung zwischen den einzelnen Bahnen des Laminats hergestellt werden kann. Diese Erwärmung bedeutet die Zuführung zusätzlicher Energie.

Da der Imprägniervorgang bereits im Trockentunnel beendet ist, müssen lösungsmittel- und wasserreiche Harze verwendet werden, um eine genügende Durchtränkung der Fasermatrix der Papierbahn zu erzielen. Diese Lösungsmittel und das Wasser müssen nachfolgend im Trockentunnel wiederum aus der Papierbahn entfernt werden, wozu zusätzliche Energie nötig ist. Andererseits führen die entweichenden Lösungsmitteldämpfe zu erheblichen Umweltproblemen und müssen durch aufwendige Vorrichtungen abgesaugt werden.

Eine besonders für Doppelbandpressen geeignete, zur Imprägnierung der Papierbahnen dienende Auftrags- und Dosiereinrichtung für das Harz ist aus der DE-PS 31 14 592 bekannt. Diese Auftrags- und Dosiereinrichtung kann anstelle der herkömmlichen Imprägniermaschine in einem Verfahren gemäß der DE-AS 27 22 262 eingesetzt werden. Damit ist auch diese Auftrags- und Dosiereinrichtung vor der Doppelbandpresse angeordnet. Anregungen, wie die obengenannten Nachteile behoben werden könnten, vermag somit diese Patentschrift dem Fachmann nicht zu geben.

Des weiteren ist aus der DE-A-35 40 389 eine Doppelbandpresse bekannt, bei der auf dem Trum des Endlosbandes, das von der Auslaufzone der Doppelbandpresse zur Einlaufzone in die Doppelbandpresse zurückläuft, ein thermoplastisches Harzgemisch in Pulverform aufgestreut wird. Diese Pulverschicht wird auf ihrem Weg zur Umlenkstelle an der Umlenkwalze durch eine Heizeinrichtung in der Form von Infrarot-Strahlern und/oder durch Heizeinrichtungen unter dem Band gerade soweit erhitzt, daß sie anschmilzt und an der Oberfläche des Obertrums anhaftet. Die erweichte Harzschicht läuft dann mit dem Band um die Umlenkwalze und gelangt in den Preßspalt vor dem Preßbereich, wo sie dann mit der Glasfasermatte in Berührung kommt und im Preßbereich unter Einwirkung von Temperatur und Druck die Glasfasermatte durchdringen kann. Der Vorteil, der bei einer derart ausgestalteten Doppelbandpresse erreicht werden kann, besteht darin, daß das Harz in trockener Form pulverisiert auf die Bänder feindosiert aufgebracht werden kann, ohne daS, bedingt durch die Anordnung, dieses pulverförmige Harz unkontrolliert vom Obertrum des oberen Bandes abrutschen kann.

Die Aufgabe der Erfindung besteht darin, das einstufige Verfahren zur kontinuierlichen Herstellung von Laminaten so zu verbessern, daß die Länge der gesamten Vorrichtung verkürzt und nicht wesentlich größer als diejenige der Doppelbandpressen-Anlage beim zweistufigen Verfahren ist sowie eine leichtere Führung der Material bahnen zu ermöglichen.

Die Lösung dieser Aufgabe wird durch die im Kennzeichen des Patentanspruchs 1 beschriebene technische Lehre vermittelt. Eine zur Durchführung dieses Verfahrens dienende Vorrichtung wird im Kennzeichen des Patentanspruchs 22 angegeben.

Weitere vorteilhafte Ausgestaltungen der Erfindung sind in den Unteransprüchen angegeben. So kann die Imprägniereinrichtung zur Aufbringung des Harzes auf die Materialbahn in der Nähe der auslaufseitigen Umlenktrommeln angeordnet sein und die Materialbahn mittels Umlenkrollen auf das rücklaufende Trum des Endlosbandes der Doppelbandpresse aufgelegt werden. Das rücklaufende Trum des Endlosbandes kann durch wärmeleitende Elemente oder Infrarotstrahler beheizbar ausgebildet sein oder von den beheizbar ausgebildeten auslaufseitigen Umlenktrommeln der Doppelbandpresse erwärmt werden, so daß die restlichen im Harz enthaltenen Lösungsmittel entfernt werden können und das Harz bis zum gewünschten Grad vor Einlauf in die Reaktionszone der Doppelbandpresse weiter gehärtet werden kann.

Die mit der Erfindung erzielten Vorteile bestehen insbesondere darin, daß Teile der der Verpressung vorgeschalteten Prozesse bei der Laminatherstellung in die Doppelbandpresse selbst integriert werden können. Dadurch wird die Länge der Doppelbandpressen-Anlage verkürzt, wodurch geringere Investitions- und Betriebskosten anfallen und weniger Personal zur Bedienung der Doppelbandpressen-Anlage nötig ist. Die Materialbahn wird schon während des Imprägniervorgangs oder unmittelbar danach vom Endlosband abgestützt, so daß eine separate Führung und Steuerung der Material bahnen zum Einlauf in die Doppelbandpresse nicht notwendig ist. Dadurch ist die Gefahr von Rissen in der Materialbahn völlig eliminiert, was wiederum eine Verringerung des Ausschußes sowie eine Verringerung der Stillstandszeiten der Doppelbandpressen-Anlage bedeutet.

Die erfindungsgemäße Vorrichtung gestattet die Verwendung von lösungsmittelarmen, hochviskosen Harzen, die zudem völlig wasserfrei sein können. Dadurch fallen kaum Lösungsmitteldämpfe an, so daß zur Absaugung dieser geringen Lösungsmitteldämpfe einfache Absaugeinrichtungen an der Doppelbandpresse genügen. Die durch die Lösungsmitteldämpfe ansonsten hervorgerufenen Umweltprobleme werden daher eliminiert. Außerdem wird die Gefahr von Fehlstellen durch Einschluß von Dampfblasen und Hohlräumen bei der Verpressung erheblich verringert, so daß eine qualitative Verbesserung der nach dem erfindungsgemäßen Verfahren hergestellten Laminate resultiert. Da weiter eine starke Trocknung der beharzten Materialbahnen und ein anschließendes Wiederaufschmelzen des Harzes am Einlauf in die Doppelbandpresse entfällt, wird mit der Erfindung eine beträchtliche Energieeinsparung erzielt.

Ein Ausführungsbeispiel für eine Vorrichtung zur Durchführung des erfindungsgemäßen Verfahrens ist in den Zeichnungen dargestellt und wird im folgenden näher beschrieben. Es zeigen
- Fig. 1: eine Gesamtansicht einer Vorrichtung zur Herstellung von Dekorlaminaten,
- Fig. 2: eine Doppelbandpresse im Schnitt,
- Fig. 3: die Auslaufzone an der unteren Preßbandeinheit einer Doppelbandpresse mit einer Imprägniermaschine zur Beharzung der Materialbahnen,
- Fig. 4: eine Vorrichtung zur Herstellung von Dekorlaminaten in einer abgewandelten Form,
- Fig. 5: eine Vorrichtung zur Herstellung von kupferkaschierten Laminaten und
- Fig. 6: eine Vorrichtung zur Herstellung von kupferkaschierten Laminaten in einer weiteren Ausführungsform.

Die Erfindung soll zunächst an einer Vorrichtung zur kontinuierlichen Herstellung von Dekorlaminaten erläutert werden. Üblich ist bei solchen kontinuierlich hergestellten Dekorlaminaten ein zwei- oder dreischichtiger Aufbau. Die erste Schicht besteht dabei aus einer Kernlage aus dickerem Papier und die zweite Schicht aus einer Lage von Dekorpapier, das mit dem gewünschten Druckmuster versehen ist. Die beim dreischichtigen Aufbau weiter vorhandene dritte Lage besteht aus einem dünnen Overlay-Papier. Die Dekorlage und die Overlay-Lage sind harzreicher beharzt als die Kernlage, so daß die Overlay-Lage aufgrund des dünnen Papieres durchsichtig ist. Zur Beharzung wird für die Kernlage in der Regel Phenolharz verwendet. Für die Dekor- und Overlay-Lage verwendet man meistens Melaminharz.

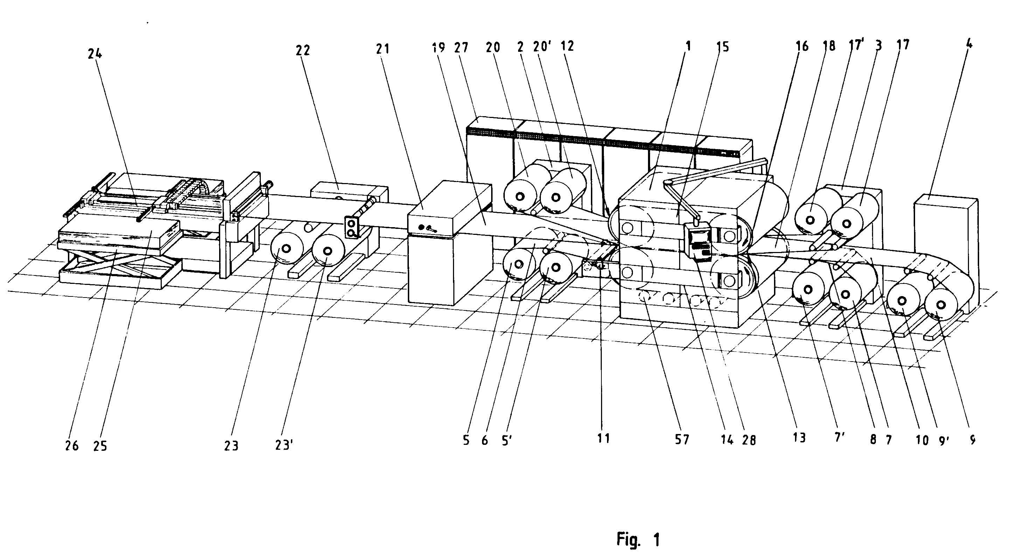

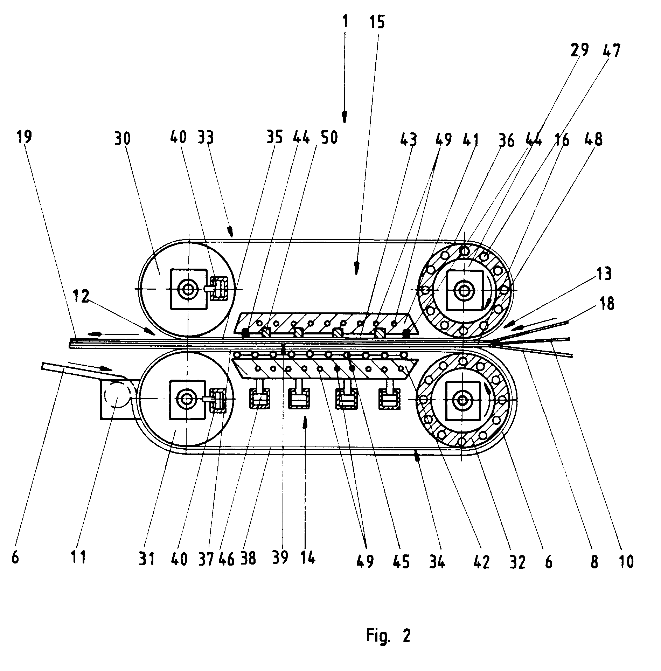

Die in Fig. 1 gezeigte Vorrichtung dient zur Herstellung von strukturierten, dreischichtigen Dekorlaminaten. Sie besteht aus einer Doppelbandpresse 1 mit mehreren vor- und nachgeschalteten Anlagenteilen. Bei der Auslaufzone 12 der Doppelbandpresse 1 ist eine Abwickeleinheit 2 angeordnet, in der sich eine Rolle 5 mit unbeharztem Kernpapier befindet. Von dieser Rolle 5 wird die Kernpapierbahn 6 kontinuierlich abgezogen, durch eine Harzauftragseinrichtung 11, die direkt an der Auslaufzone 12 der Doppelbandpresse 1 an der unteren Preßbandeinheit 14 angeordnet ist, hindurchgeführt und dort mit dem Harz versehen. Bei Verlassen der Harzauftragseinrichtung 11 wird die beharzte Kernpapierbahn 6 auf das zur Einlaufzone 13 rücklaufende Bandtrum 38 (siehe auch Fig. 2) der unteren Preßbandeinheit 14 in der Doppelbandpresse 1 aufgelegt und von diesem zur Einlaufzone 13 in der Doppelbandpresse 1 transportiert. Auf diesem rücklaufendem Bandtrum 38 finden entsprechend dem erfindungsgemäßen Verfahren die Imprägnier-und Trocknungsprozesse für die Kernpapierbahn 6 statt.

Bei der Einlaufzone 13 der Doppelbandpresse 1 sind zwei weitere Abwickeleinheiten 3, 4 angeordnet. In der Abwickeleinheit 3 befindet sich eine Rolle 7 für bereits beharztes Dekorpapier und in der Abwickeleinheit 4 eine Rolle 9 für beharztes Overlay-Papier. Von den Rollen 7 und 9 werden die Dekorpapierbahn 8 und die Overlay-Papierbahn 10 kontinuierlich abgezogen, zur Einlaufzone 13 in die Doppelbandpresse 1 geführt und dort mit der bereits auf dem Bandtrum der unteren Preßbandeinheit 14 befindlichen Kernpapierbahn 6 in der dem Aufbau des Dekorlaminats entsprechenden Reihenfolge zu einem Schichtgebilde 16 zusammengeführt. In der Abwickelstation 3 befindet sich eine weitere Rolle 17, von der eine Releasepapierbahn 18 abgezogen und an der Einlaufzone 13 in die Doppelbandpresse 1 mit dem Schichtgebilde 16 so zusammengeführt wird, daß die Releasepapierbahn 18 auf der Overlay-Papierbahn 10 aufliegt. Für jede Rolle 5, 7, 9, 17 sind in den Abwickeleinheiten 2, 3, 4 Ersatzrollen 5′, 7′, 9′, 17′ angeordnet, so daß bei zu Ende gehender Bahn die Bahn von der entsprechenden Ersatzrolle ohne Produktionsunterbrechung weiterverwendet werden kann.

In der Doppelbandpresse 1 wird das aus den beharzten Papierbahnen 6, 8, 10 bestehende Schichtgebilde 16 unter Wärmeeinwirkung und Flächendruck zu einer Dekorlaminatbahn 19 verpreßt, wobei sich die Struktur der Releasepapierbahn 18 in die Oberfläche der Dekorlaminatbahn 19 einprägt. An der Auslaufzone 12 der Doppelbandpresse 1 wird die Releasepapierbahn 18 von der Dekorlaminatbahn 19 getrennt und auf eine Aufwickelrolle 20 in der Abwickeleinheit 2 aufgewickelt. In der Abwickeleinheit 2 ist ebenfalls eine Ersatzaufwickelrolle 20′ für die Releasepapierbahn von der Ersatzrolle 17′ angeordnet. Die Dekorlaminatbahn 19 läuft dann mit gleichförmiger Geschwindigkeit weiter durch eine Kühleinrichtung 21 hindurch. Anschließend kann die Dekorlaminatbahn 19 in einer Aufwickelstation 22 auf Rollen 23 bzw. Ersatzrollen 23′ aufgewickelt werden. Alternativ kann die Dekorlaminatbahn 9 auch in einer Querschneidestation 24 in Platten 25 aufgeteilt werden, die in Paletten 26 gestapelt werden. Die gesamte Doppelbandpressen-Anlage wird von einem Computer in einem Schaltschrank 27 gesteuert. Die Dateneingabe durch den Benutzer erfolgt über das Datensichtgerät 28.

Die kontinuierlich arbeitende Doppelbandpresse 1 wird in Fig. 2 näher gezeigt. Sie besteht aus einer unteren Preßbandeinheit 14 und oberen Preßbandeinheit 15, die übereinander angeordnet sind. Die Preßbandeinheiten 14, 15 setzen sich aus je zwei Umlenktrommeln 29, 30 bzw. 31, 32 und je einem endlosen Preßband 33, 34 zusammen, das um die Umlenktrommeln 29, 30 bzw. 31, 32 herumgeführt ist. Die vier Umlenktrommeln 29, 30 bzw. 31, 32 sind in einem in der Zeichnung aus Übersichtlichkeitsgründen nicht dargestellten Pressengestell drehbar gelagert, so daß sich die beiden Preßbänder 33, 34 entsprechend den Pfeilen in den Umlenktrommeln 29, 32 bewegen. Das obere Preßband 33 besitzt damit ein unteres Bandtrum 35, das von der Einlaufzone 13 zur Auslaufzone 12 vorläuft und ein oberes Bandtrum 36, das von der Auslaufzone 12 zur Einlaufzone 13 zurückläuft. Beim unteren Preßband 34 läuft das obere Bandtrum 37 vor und das untere Bandtrum 38 zurück. Zwischen dem unteren, vorlaufenden Bandtrum 35 des oberen Preßbandes 33 und dem oberen, vorlaufenden Bandtrum 37 des unteren Preßbandes 34 liegt die Reaktionszone 39, in der das in der Zeichnung von rechts nach links vorlaufende, aus den beharzten Papierbahnen 6, 8, 10 bestehende Schichtgebilde 16 unter Flächendruck und Wärmeeinwirkung verpreßt wird. Die gewöhnlicherweise aus einem hochzugfesten Stahlband bestehenden Preßbänder 33, 34 werden mit bekannten Mitteln, beispielsweise Hydraulikzylindern 40 gespannt.

Der auf das Schichtgebilde 16 in der Reaktionszone 39 der Doppelbandpresse 1 ausgeübte Flächendruck wird über Druckplatten 41, 42 auf die Innenseiten der Preßbänder 33, 34 hydraulisch oder mechanisch aufgebracht und von diesen dann auf das zu verpressende Schichtgebilde 16 übertragen. Die vom Schichtgebilde 16 ausgeübten Reaktionskräfte werden über die Druckplatten 41, 42 wiederum in das Pressengestell eingeleitet.

Bei der hydraulischen Druckübertragung wird ein unter Druck setzbares fluides Druckmedium in den Raum zwischen der Druckplatte 41 und der Innenseite des Preßbandes 33 gebracht, wie in Fig. 2 anhand der oberen Preßbandeinheit 15 gezeigt ist. Zu den Seiten ist dieser Raum, die sogenannte Druckkammer 43, von einer ringförmig in sich geschlossenen, in der Druckplatte 41 angebrachten und auf der Innenseite des Preßbandes 33 gleitenden Gleitflächendichtung 44 begrenzt. Als Druckmedium wird vorzugsweise ein synthetisches Öl verwendet. Genausogut kann jedoch auch ein Gas, beispielsweise Druckluft verwendet werden.

Zur mechanischen Erzeugung des auf das Schichtgebilde 16 einwirkenden Flächendrucks sind zwischen der Druckplatte 42 und der Innenseite des Preßbandes 34 ortsfeste Rollen 45 angeordnet, wie in Fig. 2 an der unteren Preßbandeinheit 14 gezeigt ist. Mit Hilfe von Hydraulikzylindern 46 wird die Druckplatte 42 mitsamt den Rollen 45 gegen die Innenseite des Preßbandes 34 angestellt.

Selbstverständlich kann auch die Druckplatte 41 mit einem mechanischen Druckübertragungssystem bzw. die Druckplatte 42 mit einem hydraulischen Druckübertragungssystem versehen sein. Falls gewünscht, kann die Druckübertragung auch kombiniert hydraulisch/mechanisch erfolgen, indem die beiden geschilderten Prinzipien gleichzeitig angewandt werden.

Zur Übertragung der vom Schichtgebilde 16 in der Reaktionszone 39 der Doppelbandpresse 1 benötigten Wärme, sind die einlaufseitigen Umlenktrommeln 29, 32 beheizbar ausgebildet. Dazu befinden sich Kanäle 47 im Mantel 48 der einlaufseitigen, zylindrischen Umlenktrommeln 29, 32. Durch die Kanäle 47 zirkuliert ein Wärmeträgermittel, beispielsweise ein Thermoöl, das durch Konvektion Wärme an die Umlenktrommeln 29, 32 abgibt. Die Wärme der Umlenktrommeln 29, 32 wird von diesen auf die Preßbänder 33, 34 übertragen und von diesen schließlich in der Reaktionszone 39 an das Schichtgebilde 16 abgegeben. Anstelle der Erwärmung mittels eines in den Kanälen 47 zirkulierenden Wärmeträgermittels können auch elektrisch betriebene Heizpatronen in den Mänteln 48 der einlaufseitigen Umlenktrommeln 29, 32 angeordnet sein.

Zur weiteren Erwärmung des Schichtgebildes 16 in der Reaktionszone 39 oder alternativ können die Druckplatten 41, 42 als Heizplatten ausgebildet sein. Zu diesem Zweck befinden sich Kanäle 49 in den Druckplatten 41, 42, die ebenfalls von einem Wärmeträgermittel durchflossen werden. Das Wärmeträgermittel gibt während der Strömung durch die Kanäle 49 Wärme mittels konvektiver Wärmeübertragung an die Druckplatten 41, 42 ab. Die Druckplatten 41, 42 werden dabei auf eine Temperatur erwärmt, die höher als die Temperatur der Preßbänder 33, 34 in der Reaktionszone 39 ist. Bei der mechanischen Druckübertragung wird dann aufgrund des Wärmegefälles Wärme von der Druckplatte 42 auf das Preßband 34 über die Rollen 45, die aus einem gut wärmeleitfähigen Metall bestehen, übertragen. Bei der hydraulischen Druckübertragung sind in der Druckplatte 41 wärmeleitende Elemente 50 angeordnet. Diese wärmeleitenden Elemente 50 bestehen aus einem gut wärmeleitfähigen Material, besitzen mit einer Fläche einen guten Wärmeleitkontakt zu der Druckplatte 41 und berühren mit einer weiteren Fläche die Innenseite des Preßbandes 33, so daß die Innenseite des Preßbandes 33 an dieser Fläche der wärmeleitenden Elemente 50 entlanggleitet. Aufgrund des Wärmegefälles zwischen der Druckplatte 41 und dem Preßband 33 wird somit Wärme von der Druckplatte 41 über die wärmeleitenden Elemente 50 auf das Preßband 33 übertragen. Diese Wärme wird vom Preßband 33 dann an das Schichtgebilde 16 weitergegeben. Die nähere Ausbildung der wärmeleitenden Elemente ist aus der DE-OS 33 25 578 an sich bekannt und braucht daher hier nicht näher erläutert zu werden.

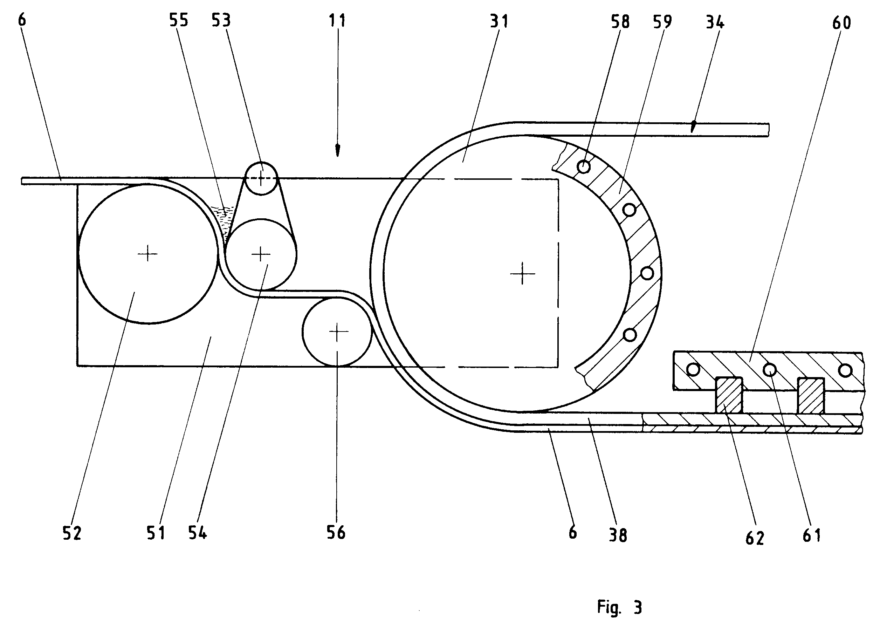

In Fig. 3 ist die zur Beharzung der Kernpapierbahn 6 dienende Harzauftragseinrichtung 11 näher gezeigt. Die Harzauftragseinrichtung 11 ist in einem kastenförmigen Gestell 51 eingebaut, von dem in Fig. 3 aus Übersichtlichkeitsgründen nur die Rückfront eingezeichnet ist. Das Gestell 51 ist bei der auslaufseitigen Umlenktrommel 31 der unteren Preßbandeinheit 14 der Doppelbandpresse 1 am Pressengestell befestigt. In dem Gestell 51 ist eine quer über die Breite reichende Stützwalze 52 drehbar gelagert. Über diese Stützwalze 52 läuft die unbeharzte Kernpapierbahn 6 in die Harzauftragseinrichtung 11 ein und wird mittels einer kleineren, um eine Achse 53 verschwenkbaren Dosierwalze 54 an die Stützwalze 52 angelegt. Die Dosierwalze 54 reicht ebenfalls über die Breite der Harzauftragseinrichung 11. Die Achse 53 ist am Gestell 51 drehbar gelagert.

In dem zwischen der Stützwalze 52 und der Dosierwalze 54 gebildeten Raum, der seitlich von dem Gestell 51 abgedichtet ist, befindet sich das zur Imprägnierung der Kernpapierbahn 6 dienende duroplastische, im A-Zustand befindliche Harz 55. Es handelt sich hier um ein hochviskoses, lösungsmittelarmes Harz, in diesem Ausführungsbeispiel um Phenolharz. Die kontinuierlich durch den Spalt zwischen der Stützwalze 52 und der Dosierwalze 54 durch den das Harz 55 enthaltenden Raum laufende Kernpapierbahn 6 nimmt das hochviskose, lösungsmittelarme Harz 55 oberflächlich auf. Die Menge des aufgenommenen Harzes 55 wird durch die Bahngeschwindigkeit der Kernpapierbahn 6, die Viskosität und Temperatur des Harzes 55, die Anpressung der Dosierwalze 54, usw. gesteuert.

Die mit Harz versehene Kernpapierbahn 6 wird dann weiter einer Umlenkwalze 56 zugeführt, die ebenfalls drehbar im Gestell 51 befestigt ist. Mit Hilfe dieser Umlenkwalze 56 wird die Kernpapierbahn 6 an das rücklaufende Bandtrum 38 des Preßbandes 34 auf der auslaufseitigen Umlenktrommel 31 angelegt und vom rücklaufenden Bandtrums 38 in dessen Vorlaufrichtung weiter transportiert. Die weitere Ausgestaltung der Harzauftragseinrichtung 11 dieses Ausführungsbeispiels ist aus der DE-PS 31 14 592 bekannt und braucht deshalb hier nicht weiter erläutert zu werden.

Während des Transports durch das von der Auslaufzone 12 zur Einlaufzone 13 der Doppelbandpresse 1 zurücklaufenden Bandtrums 38 des Preßbandes 34 klebt die Kernpapierbahn 6 an diesem Bandtrum 38, da es sich bei dem Harz 55 für die Kernpapierbahn 6 um ein hochviskoses, lösungsmittelarmes Harz handelt. Zur weiteren Abstützung des Preßbandes 34 und zur sicheren Verhinderung der Ablösung der Kernpapierbahn 6 vom Preßband 34 können am unteren rücklaufenden Bandtrum 38 des Preßbandes 34 nebeneinanderliegende Stützwalzen 57 vorgesehen sein (siehe Fig. 1). Mit Hilfe dieser Stützwalzen 57 erhält man gleichzeitig die Möglichkeit, auch niedrigviskose, lösungsmittelreiche Harze beim erfindungsgemäßen Verfahren zu verwenden, obwohl die Verwendung lösungsmittelarmer Harze bevorzugt wird.

Gemäß dem Verfahren nach der Erfindung finden die Imprägnier- und Trocknungsprozesse der Kernpapierbahn 6, die der Verpressung der Kernpapierbahn 6 mit den übrigen beharzten Bahnen 8, 10 vorgelagert sind, während des Transports auf dem rücklaufenden Bandtrum 38 des Preßbandes 34 statt. Da die Preßbänder 33, 34 zur Verpressung des Schichtgebildes 16 in der Reaktionszone 39 erwärmt werden, besitzen sie an der Auslaufzone 12 der Doppelbandpresse 1 noch eine gewisse Restwärme. Somit wird die auf dem rücklaufenden Bandtrum 38 aufliegende, mit dem Harz 55 versehene Kernpapierbahn 6 beim Transport zu der Einlaufzone 13 der Doppelbandpresse 1 ebenfalls erwärmt, wobei sich aufgrund des Klebens der Kernpapierbahn 6 am rücklaufenden Bandtrums 38 ein guter Wärmeübergang vom Preßband 34 auf das Harz 55 der Kernpapierbahn 6 ergibt.

Die Erwärmung des Harzes 55 auf dem rücklaufenden Bandtrum 38 des Preßbandes 34 bewirkt, daß das Harz 55 weiter aushärtet. Gleichzeitig wird es durch die Erwärmung schmelzflüssig. Dadurch dringt das Harz 55 in die Kernpapierbahn 6 ein und wird von der Fasermatrix der Kernpapierbahn 6 aufgenommen. Wenn die Kernpapierbahn 6 an der unteren, einlaufseitigen Umlenktrommel 32 der Doppelbandpresse 1 (siehe Fig. 2) angelangt ist, ist daher die Kernpapierbahn 6 voll ständig mit dem Harz 55 imprägniert und dieses Harz bis zum B-Zustand vorgehärtet. Aufgrund der Erwärmung befindet sich das von der Kernpapierbahn 6 aufgenommene Harz an der Einlaufzone 13 in die Doppelbandpresse 1 in der Gelphase, einem halbflüssigem Zustand, der zur Verbindung zwischen den einzelnen Papierbahnen 6, 8, 10 des Schichtgebildes 16 in der Reaktionszone 39 der Doppelbandpresse 1 benötigt wird. Gegenüber dem herkömmlichen Verfahren erübrigt sich beim erfindungsgemäßen Verfahren daher vorteilhafterweise ein Wiederaufschmelzen des vorgehärteten Harzes, woraus letztendlich eine Energieeinsparung resultiert.

Durch die Erwärmung auf dem rücklaufenden Bandtrum 38 des Preßbandes 34 erniedrigt sich die Viskosität des Harzes 55, so daß eine ausreichende Imprägnierung der Kernpapierbahn 6 auch bei Verwendung von hochviskosen, lösungsmittelfreien oder zumindestens lösungsmittelarmen Harzen gewährleistet ist. Das wenige im Harz enthaltene Lösungsmittel wird durch die Erwärmung ebenfalls verdampft und kann durch entsprechende Einrichtungen an der Doppelbandpresse 1 abgesaugt und rückgekühlt werden. Dieses Kondensat des Lösungsmittels kann zur Aufbereitung des Harzes 55 wieder rückgeführt werden. Da einerseits nur sehr wenig Lösungsmittel anfällt, da es sich um ein lösungsmittelarmes Harz handelt und andererseits das wenige Lösungsmittel aufgefangen und im Kreislauf wiederverwendet wird, entweicht kaum Lösungsmittel in den umgebenden Raum. Damit werden die bisherigen Umweltprobleme bei der Herstellung von Dekorlaminaten zumindestens verkleinert. Besonders hervorzuheben ist, daß kein Wasser als zusätzliches Lösungsmittel benötigt wird, so daß die Gefahr von Fehlstellen im Dekorlaminat durch Einschluß von Dampfblasen und Hohlräumen bei der Verpressung des Schichtgebildes 16 eliminiert ist.

Sollte die im Preßband 34 an der Auslaufzone 12 in der Doppelbandpresse 1 noch enthaltene Restwärme für die Imprägnierung und Weiterhärtung des in der Kernpapierbahn 6 enthaltenen Harzes 55 nicht ausreichen, so kann die untere, auslaufseitige Umlenktrommel 31 ebenfalls beheizbar ausgebildet sein. Dazu befinden sich Kanäle 58 im Mantel 59 der auslaufseitigen, zylindrischen Umlenktrommel 31, wie in Fig. 3 gezeigt ist. Mittels eines in den Kanälen 58 zirkulierenden Wärmeträgermittels wird die Umlenktrommel 31 und damit das Preßband 34 an der Auslaufzone 12 der Doppelbandpresse 1 erwärmt. Die Wärme wird vom Preßband 34 schließlich an die Kernpapierbahn 6 weitergegeben. Anstelle der Kanäle 58 können im Mantel 59 der Umlenktrommel 31 auch elektrisch betriebene Heizpatronen zur Erwärmung der Umlenktrommel 31 eingesetzt sein.

Zur weiteren Beheizung des rücklaufenden Bandtrums 38 des Preßbandes 34 kann im Pressengestell eine Heizplatte 60 entlang der Innenseite des rücklaufenden Bandtrums 38 mit einem gewissen Abstand zum Bandtrum 38 angeordnet sein. Sie besitzt Kanäle 61, die ebenfalls von einem Wärmeträgermittel durchflossen werden, das die Heizplatte 60 auf eine höhere Temperatur als das Preßband 34 erwärmt. In der Heizplatte 60 sind wärmeleitende Elemente 62 angeordnet, die entsprechend den wärmeleitenden Elementen 50 ausgebildet sind und mit einer Fläche mit gutem Wärmeleitkontakt mit der Heizplatte 60 verbunden sind sowie mit einer weiteren Fläche die Innenseite des rücklaufenden Bandtrums 38 des Preßbandes 34 berühren. Aufgrund des Wärmegefälles zwischen der Heizplatte 60 und dem Preßband 34 wird Wärme von der Heizplatte 60 über die wärmeleitenden Elemente 62 auf das Preßband 34 übertragen. Diese zusätzliche Wärme wird vom Preßband 34 dann an die Kernpapierbahn 6 weitergegeben. Zusätzlich oder auch anstelle der Erwärmung durch die Heizplatte 60 können zur Erwärmung des rücklaufenden Bandtrums 38 des Preßbandes 34 auch Infrarotstrahler angeordnet werden.

Bei der beschriebenen Vorrichtung wird das rücklaufende Bandtrum 38 des Preßbandes 34 der unteren Preßbandeinheit 14 der Doppelbandpresse 1 für die Imprägnier- und Trocknungsprozesse benützt. Selbstverständlich kann auch das rücklaufende Bandtrum 36 des Preßbandes 33 der oberen Preßbandeinheit 15 (siehe Fig. 2) dafür verwendet werden, wobei die Harzauftragseinrichtung dann an der auslaufseitigen Umlenktrommel 30 befestigt ist.

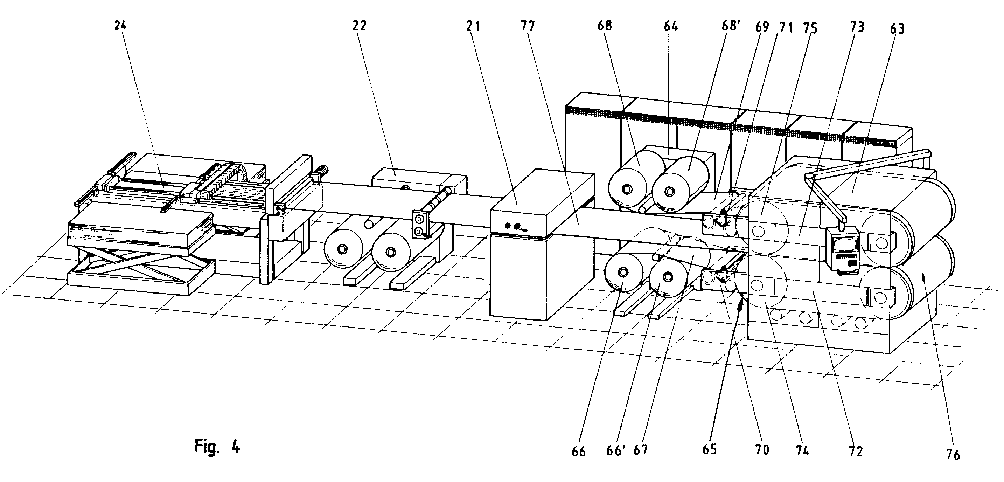

Ebenso ist es möglich, die rücklaufenden Bandtrums beider Preßbandeinheiten für die Imprägnier- und Trocknungsprozesse zu verwenden. In Fig. 4 ist eine solche Vorrichtung zur kontinuierlichen Herstellung von zwei schichti gen Dekorlaminaten dargestellt.

Bei dieser Ausführungsform ist eine Abwickeleinheit 64 in der Nähe der Auslaufzone 65 der Doppelbandpresse 63 angeordnet. Diese Abwickeleinheit 64 trägt eine Rolle 66 für die Kernpapierbahn 67 und eine Rolle 68 für die Dekorpapierbahn 69. Für beide Rollen 66, 68 sind Ersatzrollen 66′, 68′, in der Abwickeleinheit 64 angeordnet. Sowohl die Kernpapierbahn 67 als auch Dekorpapierbahn 69 sind unbeharzt und werden von den Rollen 66 und 68 abgezogen und durch je eine Harzauftragseinrichtung 70 bzw. 71 hindurchgeführt. Die Harzauftragseinrichtung 70 ist an der auslaufseitigen Umlenktrommel 74 der unteren Preßbandeinheit 72 angeordnet und die Harzauftragseinrichtung 71 an der auslaufseitigen Umlenktrommel 75 der oberen Preßbandeinheit 73. Während die Harzauftragseinrichtung 70 wiederum ein hochviskoses, lösungsmittelarmes Phenolharz zur Beharzung der Kernpapierbahn 67 enthält, befindet sich in der Harzauftragseinrichtung 71 ein Melaminharz für die Beharzung der Dekorpapierbahn 69. Nachdem die Kern- und Dekorpapierbahnen 67, 69 in den Harzauftragseinrichtungen 70, 71 mit Harz versehen sind, werden sie auf das rücklaufende Bandtrum der jeweiligen Preßbandeinheit 72, 73 aufgelegt und von diesem erwärmt, so daß das Harz weiter aushärtet und gleichzeitig die Papierbahnen 67, 69 imprägniert.

Von den rücklaufenden Bandtrums werden die beharzten Papierbahnen 67, 69 zur Einlaufzone 76 der Doppelbandpresse 63 geführt und dort zu einem Schichtgebilde zusammengeführt. Dieses Schichtgebilde wird anschließend in der Doppelbandpresse 63 unter Einwirkung von Wärme und Flächendruck zu einer zweischichtigen Dekorlaminatbahn 77 verpreßt, die in der Auslaufzone 65 die Doppelbandpresse 63 verläßt. Die zweischichtige Dekorlaminatbahn 77 kann dann, wie bereits weiter oben beschrieben, eine Kühleinrichtung 21 und eine Aufwickelstation 22 oder alternativ eine Querschneidestation 24 durchlaufen.

In den den Harzauftragseinrichtungen 11, 70, 71 wird das Harz in einem hochviskosen, flüssigen Zustand oberflächlich auf die Papierbahn aufgebracht. Es ist jedoch auch möglich, das Harz als Pulver durch Streuen oder Spritzen in der Nähe der Auslaufzone oberflächlich auf die Papierbahn aufzubringen und diese dann auf das rücklaufende Bandtrum eines Preßbandes aufzulegen. Durch die Wärmeeinwirkung des rücklaufenden Bandtrums schmilzt das pulverförmige Harz auf, dringt in die Fasermatrix der Papierbahn ein und imprägniert diese. Gleichzeitig härtet das Harz dabei weiter aus.

Selbstverständlich können mit dem anhand der Herstellung von Dekorlaminaten beschriebenen Verfahren und der zugehörigen Vorrichtung auch technische Laminate hergestellt werden. Es sind dann die für das jeweilige technische Laminat benötigten unbeharzten Material bahnen und die jeweiligen Harze zu verwenden

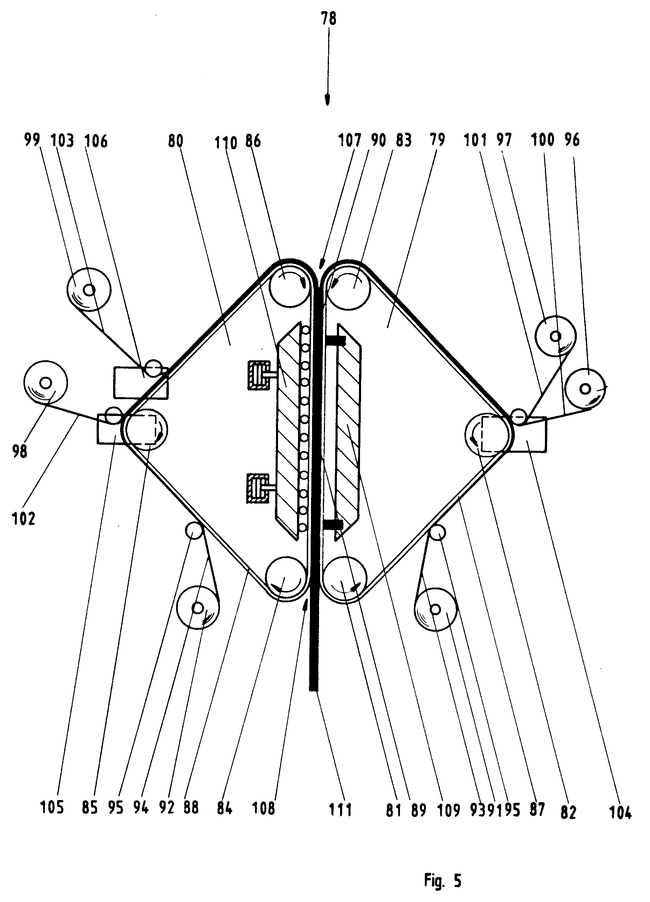

In einem weiteren Ausführungsbeispiel zur Durchführung des erfindungsgemäßen Verfahrens ist in Fig. 5 eine Anlage zur Herstellung von kupferkaschierten Laminaten dargestellt. Hier besteht die Doppelbandpresse 78 aus zwei vertikal aufgestellten Doppelbandeinheiten 79, 80. Jede Doppelbandeinheit 79, 80 besitzt jeweils drei in Form eines gleichschenkligen Dreiecks angeordnete Umlenktrommeln 81, 82, 83 bzw. 84, 85, 86, über die je ein Preßband 87, 88 gespannt ist. Die beiden Doppelbandeinheiten 79, 80 sind in einem nicht dargestellten Pressengestell so angeordnet, daß die zwischen den Umlenktrommeln 81, 83 bzw. 84, 86 gebildeten Grundseiten des Dreiecks vertikal stehen und dazwischen die Reaktionszone 89 bilden. Der Druck auf die Preßbänder 87, 88 in der Reaktionszone 89 wird über Druckplatten 109, 110 mechanisch oder hydraulisch auf die Innenseiten der Preßbänder 87, 88 aufgebracht und von diesen auf das zu verpressende Schichtgebilde 90 übertragen. Das Prinzip der mechanischen oder hydraulischen Druckübertragung ist bereits weiter oben für die Doppelbandpresse 1 anhand der Fig. 2 beschrieben.

In der Nähe der auslaufseitigen Umlenktrommeln 81, 84 sind Abwickeleinheiten angebracht, in denen sich Rollen 91, 92 für die Kupferfolien befinden. Von diesen Rollen 91, 92 werden Kupferfolienbahnen 93, 94 kontinuierlich abgezogen und über Umlenkrollen 95 auf das zwischen den Umlenktrommeln 81, 82 bzw. 84, 85 befindliche, sich kontinuierlich bewegende Bandtrum des Preßbandes 87 bzw. 88 aufgelegt. Diese Kupferfolienbahnen 93, 94 werden mit den Preßbändern 87, 88 in Richtung der nächstliegenden Umlenktrommel 82 bzw. 85 transportiert und dabei von den erwärmten Preßbändern 87, 88 vorgewärmt.

In der Nähe der an der Spitze des gleichschenkligen Dreiecks befindlichen Umlenktrommeln 82, 85 sind Abwickeleinheiten angebracht, in denen sich Rollen 96, 97, 98, 99 mit unbeharztem Glasgewebe befinden. Von den Rollen 96, 97 werden die Glasgewebebahnen 100, 101 abgezogen und durch eine Harzauftragseinrichtung 104 gemeinsam hindurchgeführt. Die Harzauftragseinrichtung 104, die entsprechend der weiter oben anhand der Fig. 3 näher beschriebenen Harzauftragseinrichtung 11 ausgestaltet ist, ist bei der Umlenktrommel 82 angeordnet und enthält ein hochviskoses, lösungsmittelarmes Epoxyharz. Beim Durchlauf durch die Harzauftragseinrichtung 104 werden die unbeharzten Glasgewebebahnen 100, 101 mit dem Epoxyharz versehen und anschließend auf die bereits auf dem Preßband 87 befindliche Kupferfolienbahn 93 an der Umlenktrommel 82 aufgelegt.

Die solchermaßen aufeinandergeschichteten Kupferfolienbahn 93 und Glasgewebebahnen 100, 101 werden mit dem zur Einlaufzone 107 rücklaufenden Bandtrum des Preßbandes 87 weiter in Richtung zu der Umlenktrommel 83 transportiert. Dabei wird Wärme vom Preßband 87 über die Kupferfolienbahn 93 auf die mit Epoxyharz versehenen Glasgewebebahnen 100, 101 übertragen und das restliche Lösungsmittel des Epoxyharzes verdunstet. Gleichzeitig härtet das Epoxyharz weiter aus, wird schmelzflüssig und dringt in die Glasgewebematrix ein, so daß die Glasgewebebahnen 100, 101 mit Epoxyharz imprägniert werden. Die nötige Wärme kann wiederum über die Umlenktrommeln 81, 82 oder durch mit Wärmebrücken ausgestattete, an der Innenseite des Preßbandes 87 angeordnete Heizplatten, die wie anhand der Fig. 3 erläutert ausgeführt sind, auf das Preßband 87 zugeführt werden, falls die Restwärme des rücklaufenden Bandtrums des Preßbandes 87 nicht ausreicht. Auch eine Erwärmung des rücklaufenden Bandtrums des Preßbandes 87 oder direkt der mit Harz versehenen Glasgewebebahnen 100, 101 mittels Infrarotstrahlern ist möglich.

An der in Fig. 5 rechts befindlichen Doppelbandeinheit 79 wird das Epoxyharz auf die beiden Glasgewebebahnen 100, 101 in einer einzigen Harzauftragseinrichtung 104 aufgebracht. Es ist jedoch auch möglich, für jede Glasgewebebahn eine eigene Harzauftragseinrichtung vorzusehen, wie anhand der in der Fig. 5 links liegenden Doppelbandeinheit 80 gezeigt ist. Dort sind in der Nähe der Umlenktrommel 85 zwei Harzauftragseinrichtungen 105 und 106 angeordnet. Eine unbeharzte Glasgewebebahn 102 wird von der Rolle 98 kontinuierlich abgezogen, durch die Harzauftragseinrichtung 105 hindurchgeführt und dabei mit dem Epoxyharz versehen. Anschließend wird diese Glasgewebebahn 102 auf die Kupferfolienbahn 94, die sich bereits auf dem zur Einlaufzone 107 rücklaufenden Bandtrum des Preßbandes 88 befindet, an der Umlenktrommel 85 aufgelegt. Eine weitere Glasgewebebahn 103 wird von einer Rolle 99 kontinuierlich abgezogen, durch die zweite Harzauftragseinrichtung 106 hindurchgeführt und dabei ebenfalls mit Epoxyharz versehen. Diese die Harzauftragseinrichtung 106 verlassende Glasgewebebahn 103 wird dann auf die Glasgewebebahn 102 aufgelegt, die sich bereits auf dem zur Einlaufzone 107 rücklaufenden Bandtrum des Preßbandes 88 befindet. Die Kupferfolienbahn 94 sowie die Glasgewebebahnen 102, 103 werden vom rücklaufenden Bandtrum des Preßbandes 88 in Richtung zu der Umlenktrommel 86 transportiert. Dabei imprägniert das Epoxyharz aufgrund der Wärmeeinwirkung wiederum die Glasgewebematrix.

Die Wärmezufuhr auf die Preßbänder 87, 88 bzw. deren Vorschubgeschwindigkeit wird so gewählt, daß die Glasgewebebahnen 100, 101, 102, 103 bei Erreichen der einlaufseitigen Umlenktrommeln 83, 86 der Doppelbandpresse 78 vollständig mit dem Epoxyharz imprägniert sind und das Epoxyharz bis zum B-Zustand bzw. Gelpunkt vorgehärtet ist. An den Umlenktrommeln 83 und 86 werden die Kupferfolienbahnen 93, 94 mit den aufliegenden, imprägnierten Glasgewebebahnen 100, 101, 102, 103 in Richtung auf die Reaktionszone 89 umgelenkt und an der Einlaufzone 107 der Doppelbandpresse 78 so zusammengeführt, daß sich ein Schichtgebilde 90 von harzimprägnierten Glasgewebebahnen mit auf den Oberflächen aufliegenden Kupferfolien bildet. Dieses Schichtgebilde durchläuft die Reaktionszone 89 der Doppelbandpresse 78 und wird dort unter Einwirkung von Wärme und Flächendruck verpreßt, so daß in der Auslaufzone 108 der Doppelbandpresse 78, bei den Umlenktrommeln 81, 84, die kupferkaschierte Laminatbahn 111 die Doppelbandpresse 78 verläßt. Danach kann die kupferkaschierte Laminatbahn 111 durch weitere an sich bekannte Bearbeitungseinrichtungen hindurchgeführt werden.

Im obigen Ausführungsbeispiel setzt sich der Schichtstoffkern des kupferkaschierten Laminats aus vier Materialbahnen zusammen. Je nach Erfordernis kann sich der Schichtstoffkern auch aus einer anderen Anzahl von Materialbahnen zusammensetzen. Es sind dann die Harzauftragseinrichtungen in der benötigten Anzahl vorzusehen. Selbstverständlich können mit der beschriebenen Vorrichtung auch kupferkaschierte Laminate hergestellt werden, deren Schichtstoffkern aus beharzten Papierbahnen besteht. Zur Beharzung der Materialbahnen können auch Phenol- und andere Harze eingesetzt werden. Im übrigen können mit einer solchen Vorrichtung nach dem erfindungsgemäßen Verfahren auch sonstige technische Laminate hergestellt werden.

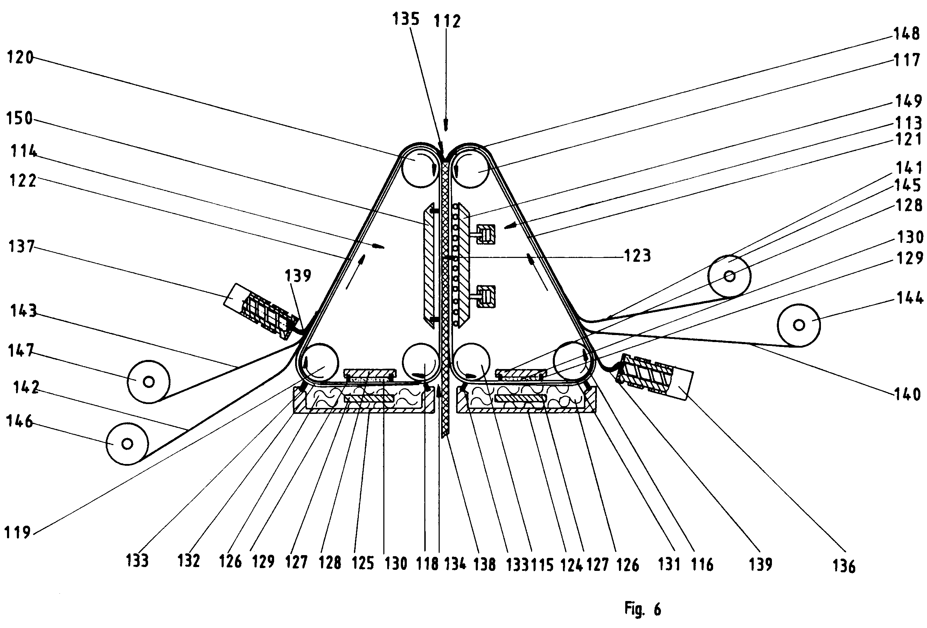

In Fig. 6 ist eine weitere Ausführungsform einer Vorrichtung zur kontinuierlichen Herstellung kupferkaschierter Laminate gezeigt. Diese Vorrichtung besteht aus einer Doppelbandpresse 112, die wiederum zwei vertikal gestellte Doppelbandeinheiten 113, 114 besitzt. Jede Doppelbandeinheit 113, 114 besitzt je drei Umlenktrommeln 115, 116, 117 bzw. 118, 119 120, über die je ein Preßband 121, 122 gespannt ist. Die Umlenktrommeln 115, 116, 117 und 118, 119, 120 sind jeweils in Form eines rechtwinkligen Dreieckes angeordnet, deren vertikal stehende Katheten die Reaktionszone 123 begrenzen.

An den Außenseiten der Preßbänder 121, 122 entlang der horizontalen Katheten, die bei der Auslaufzone 134 der Doppelbandpresse 112 beginnen, ist je ein galvanisches Kupferbad 124, 125 angeordnet. Die galvanischen Kupferbäder 124, 125 sind als Wanne ausgebildet, die mittels Dichtungen 133 gegen die Preßbänder 121, 122 abgedichtet ist und in der die das Kupfer als Ion enthaltene Badflüssigkeit 126 enthalten ist. Weiter befindet sich im galvanischen Kupferbad 124, 125 je eine metallische Platte 127, die als Anode geschaltet ist. Entlang der Innenseite der Preßbänder 121, 122, im Bereich des Kupferbades 124, 125 ist eine weitere metallische Platte 128 angeordnet, die als Kathode geschaltet ist. Mittels einer in dieser Platte 128 angebrachten, ringförmig in sich geschlossenen Dichtung 129 wird ein abgeschlossener, zwischen der metallischen Platte 128 und der Innenseite der Preßbänder 121, 122 befindlicher Raum gebildet, der eine metallische Flüssigkeit 130 enthält. Dadurch ist das Preßband 121, 122 im Bereich des Kupferbades 124, 125 ebenfalls als Kathode geschaltet, so daß sich auf dem Preßband 121, 122 je eine Kupferschicht 131, 132 abscheidet, die von den Preßbändern 121, 122 weitertransportiert wird. Diese Kupferschicht 131, 132, die das Kupferbad 124, 125 bei den Umlenktrommeln 116, 119 verläßt, dient als Kupferfolie für das herzustellende kupferkaschierte Laminat. Weitere Ausführungen zu Einzelheiten bezüglich eines solchen galvanischen Kupferbades an einer Doppelbandpresse können aus der DE-OS 35 15 629 entnommen werden und brauchen hier nicht näher erläutert zu werden.

Bei der Umlenktrommel 116 ist ein Extruder 136 mit einer Breitschlitzdüse angeordnet, deren Öffnung über die Breite der Kupferfolie 131 reicht. Mit Hilfe des Extruders 136 wird das zur Imprägnierung der Materialbahnen für den Schichtstoffkern der kupferkaschierten Laminatbahn 138 dienende hochviskose, lösungsmittelarme und mit einem nicht sehr scharfen Härter versehene Harz 139 auf die Kupferfolie 131 aufgetragen. In Vorlaufrichtung des Preßbandes 121 hinter dem Extruder 136 und auf dem zur Einlaufzone 135 der Doppelbandpresse 112 rücklaufenden Bandtrum des Preßbandes 121 werden die unbeharzten Materialbahnen, beispielsweise Glasgewebebahnen 140, 141, die von in Abwickeleinheiten befindlichen Rollen 144, 145 kontinuierlich abgezogen werden, auf die Kupferfolie 131 aufgelegt und mit dem Preßband 121 weiter in Richtung zur Einlaufzone 135 transportiert. Das auf der Kupferfolie 131 befindliche Harz 139 wird vom Preßband 121 über die Kupferfolie 131 erwärmt und dringt dabei in die Glasgewebebahnen 140, 141 ein, so daß die Glasgewebebahnen 140, 141 mit dem Harz 139 imprägniert werden. Gleichzeitig dunstet das restliche Lösungsmittel ab und das Harz 139 härtet weiter.

An der in der Fig. 6 links liegenden Doppelbandeinheit 114 ist eine modifizierte Ausführungsform für den Auftrag des Harzes zu sehen. Im Bereich der Umlenktrommel 119 werden unbeharzte Materialbahnen, beispielsweise Glasgewebebahnen 142, 143, die von in Abwickeleinheiten befindlichen Rollen 146, 147 abgezogen werden, auf die Kupferfolie 132 aufgelegt und mit dieser zusammen mit dem zur Einlaufzone 135 der Doppelbandpresse 112 rücklaufenden Bandtrum des Preßbandes 122 weiter transportiert. In Vorlaufrichtung des Preßbandes 122 gesehen, dahinter ist ein Extruder 137 angeordnet. Dieser Extruder 137 besitzt eine Breitschlitzdüse, die quer über die Breite der Glasgewebebahnen 142, 143 reicht und deren Öffnung direkt über den Glasgewebebahnen 142, 143 angeordnet ist. Vom Extruder 137 wird das zur Imprägnierung der Glasgewebebahnen 142, 143 dienende hochviskose, lösungsmittelarme Harz 139 auf die Glasgewebebahnen 142, 143 extrudiert. Während das rücklaufende Bandtrum des Preßbandes 122 die aufliegende Kupferfolie 132 und die Glasgewebebahnen 142, 143 weiter in Richtung Einlaufzone 135 transportiert, wird das auf den Glasgewebebahnen 142, 143 befindliche Harz vom Preßband 122 her erwärmt und dringt dabei in die Glasgewebematrix ein, so daß die Glasgewebebahnen 142, 143 bei Erreichen der Einlaufzone 135 vollständig imprägniert sind.

Bei der Einlaufzone 135 an den Umlenktrommeln 117, 120 werden die Kupferfolien 131, 132 mit den aufliegenden imprägnierten Glasgewebebahnen 140, 141, 142, 143 umgelenkt und zu einem Schichtgebilde 148 zusammengeführt. Dieses Schichtgebilde 148 läuft in die Doppelbandpresse 112 ein und wird in deren Reaktionszone 123 unter Einwirkung von Wärme und Flächendruck zur kupferkaschierten Laminatbahn 138 verpreßt. Der Flächendruck wird in der Reaktionszone 123 von Druckplatten 149, 150, die an den Innenseiten der Preßbänder 121, 122 angeordnet sind, mit mechanischen oder hydraulischen Mitteln ausgeübt, wie bereits weiter oben erläutert ist. Bei der Auslaufzone 134, an den auslaufseitigen Umlenktrommeln 115, 118 verläßt die kupferkaschierte Laminatbahn 138 die Doppelandpresse 112 und kann dann in weiteren, an sich bekannten Vorrichtungen weiterbearbeitet werden.

Das mit obigen Ausführungsbeispielen beschriebene erfindungsgemäße Verfahren ist grundsätzlich auch zur kontinuierlichen Herstellung von Laminaten geeignet, bei denen die Materialbahnen mit thermoplastischen Harzen imprägniert sind. In der Regel wird dann die Reaktionszone in eine der Einlaufzone in die Doppelbandpresse zugeordnete Heizzone und eine der Auslaufzone aus der Doppelbandpresse zugeordnete Kühlzone eingeteilt. Dazu wird der der Kühlzone zugeordnete Teil der Druckplatte gekühlt, indem Bohrungen in der Druckplatte angeordnet sind, die von einem Kühlmittel durchflossen werden. Mittels der bereits weiter oben beschriebenen wärmeleitenden Elementen wird die Wärme in der Kühlzone vom zu verpressenden Schichtgebilde dann über das Preßband in die Druckplatte abgeführt.

Bei den beschriebenen, das erfindungsgemäße Verfahren realisierenden Ausführungsbeispielen sind die der Verpressung vorgelagerten Imprägnier- und Trocknungsprozesse von mindestens einer Materialbahn wenigstens teilweise in die Doppelbandpresse integriert. Diese Integration führt zu einer beträchtlichen Energie- und Materialeinsparung sowie zu einer qualitativen Verbesserung des Gesamtprozesses. Außerdem können die Vorrichtungen gemäß der Erfindung kompakter als herkömmliche Vorrichtungen gebaut werden.

## Patentansprüche

1. Verfahren zur kontinuierlichen Herstellung von Laminaten, die aus mehreren Lagen von harzimprägnierten, miteinander verpreßten Materialbahnen (6) bestehen, wobei die harzfreien Materialbahnen (6) von Rollen (5) abgewickelt, mit einem durch Wärme, chemische Reaktionen oder Kühlung aushärtbaren Harz (55) imprägniert, danach unter Vorhärtung des Harzes (55) getrocknet und zu einem Schichtgebilde zusammengeführt werden, dieses Schichtgebilde anschließend in eine Doppelbandpresse (1) eingeführt und dort unter Einwirkung von Flächendruck, Wärme und/oder Kühlung zwischen zwei Endlosbändern (33,34) zur Laminatbahn verpreßt wird und diese Laminatbahn nach Verlassen der Doppelbandpresse (1) in Rollen aufgewickelt oder in Platten zerteilt wird, **dadurch gekennzeichnet**, daß die der Verpressung vorgelagerten Imprägnier- und Trocknungsprozesse von mindestens einer Materialbahn wenigstens teilweise auf dem Trum (38) des Endlosbandes der Doppelbandpresse (1) durchgeführt werden, das von der Auslaufzone (12) der Doppelbandpresse (1) zur Einlaufzone (13) in die Doppelbandpresse (1) zurückläuft.

2. Verfahren nach Patentanspruch 1, **dadurch gekennzeichnet**, daß die Imprägnier- und Trocknungsprozesse für sämtliche zu beharzenden Materialbahnen (6) auf den Trums der beiden Endlosbänder (33,34) der Doppelbandpresse (1) durchgeführt werden, die von der Auslaufzone (12) der Doppelbandpresse (1) zur Einlaufzone (13) in die Doppelbandpresse (1) zurücklaufen.

3. Verfahren nach Patentanspruch 1 oder 2, **dadurch gekennzeichnet**, daß die Materialbahn (6) mit Harz versehen wird und zwischen der ein- und auslaufseitigen Umlenktrommel (29,30) der Doppelbandpresse (1) auf das rücklaufende Trum (38) des Endlosbandes (34) aufgelegt wird und die Materialbahn (6) mit dem rücklaufenden Trum (38) zur Einlaufzone (13) in die Doppelbandpresse (1) transportiert wird.

4. Verfahren nach Patentanspruch 3, **dadurch gekennzeichnet**, daß die Materialbahn (6) mit Harz versehen wird, in der Nähe der auslaufseitigen Umlenktrommeln (30,31) der Doppelbandpresse (1) auf das rücklaufende (38) Trum des Endlosbandes (34) aufgelegt wird und die Materialbahn (6) mit dem rücklaufenden Trum (38) zur Einlaufzone (13) in die Doppelbandpresse (1) transportiert wird.

5. Verfahren nach Patentanspruch 1 oder 2, **dadurch gekennzeichnet**, daß die Materialbahn (6) auf das von der Auslaufzone (12) der Doppelbandpresse (1) zur Einlaufzone (13) in die Doppelbandpresse 1 zurücklaufende Trum (38) des Endlosbandes (34) aufgelegt und Anschließend mit Harz versehen wird.

6. Verfahren nach einem der Patentansprüche 1 bis 5, **dadurch gekennzeichnet**, daß das rücklaufende Trum (38) des Endlosbandes erwärmt wird.

7. Verfahren nach einem der Patentansprüche 1 bis 6, **dadurch gekennzeichnet**, daß zur Imprägnierung ein lösungsmittelarmes Harz verwendet wird.

8. Verfahren nach Patentanspruch 7, **dadurch gekennzeichnet**, daß zur Imprägnierung ein wasserfreies Harz verwendet wird.

9. Verfahren nach einem der Patentansprüche 1 bis 8, **dadurch gekennzeichnet**, daß das Harz auf die Materialbahn (6) oberflächlich aufgebracht wird.

10. Verfahren nach Patentanspruch 9, **dadurch gekennzeichnet**, daß das Harz als hochviskose Flüssigkeit auf die Oberfläche der Materialbahn (6) aufgebracht wird.

11. Verfahren nach Patentanspruch 10, **dadurch gekennzeichnet**, daß das Harz mittels einer Walze auf die Oberfläche der Materialbahn (6) aufgebracht wird.

12. Verfahren nach Patentanspruch 10, **dadurch gekennzeichnet**, daß das Harz auf die Materialbahn (6) extrudiert wird.

13. Verfahren nach Patentanspruch 9, **dadurch gekennzeichnet**, daß das Harz als Pulver auf die Oberfläche der Materialbahn (6) aufgebracht wird.

14. Verfahren nach Patentanspruch 13, **dadurch gekenn**zeichnet, daß das pulverförmige Harz durch Streuen oder Spritzen auf die Oberfläche der Materialbahn (6) aufgebracht wird.

15. Verfahren nach einem der Patentansprüche 1 bis 14, **dadurch gekennzeichnet**, daß das restliche Lösungsmittel, das aus dem Harz während des Trocknungsprozesses der Materialbahn (6) auf dem Endlosband (34) entweicht, aufgefangen, abgesaugt, rückgekühlt und dem Harz erneut zugeführt wird.

16. Verfahren nach einem der Patentansprüche 1 bis 15, **dadurch gekennzeichnet**, daß als Harz zur Imprägnierung der Material bahnen (6) ein duroplastisches Harz verwendet wird.

17. Verfahren nach einem der Patentansprüche 1 bis 15, **dadurch gekennzeichnet**, daß als Harz zur Imprägnierung der Materialbahnen (6) ein thermoplastisches Harz verwendet wird.

18. Verfahren nach Patentanspruch 16, **dadurch gekennzeichnet**, daß die Temperatur des Endlosbandes (34) und dessen Geschwindigkeit so gewählt wird, daß die auf dem Endlosband (34) aufliegende Materialbahn (6) bei Erreichen der Einlaufzone (13) in die Doppelbandpresse (1) völlig imprägniert ist und das Harz bis zum B-Zustand weiter gehärtet ist.

19. Verfahren nach Patentanspruch 16 oder 18, **dadurch gekennzeichnet**, daß bei der Herstellung von dekorativen Laminaten, die der Verpressung vorgelagerten Imprägnier- und Trocknungsprozesse für wenigstens das schwere Kernpapier auf dem rücklaufenden Trum (38) des Endlosbandes (34) durchgeführt werden.

20. Verfahren nach Patentanspruch 19, **dadurch gekennzeichnet**, daß die der Verpressung vorgelagerten Imprägnier-und Trocknungsprozesse für die Dekorpapierbahn ebenfalls auf dem rücklaufenden Trum (38) des Endlosbandes (34) durchgeführt werden.

21. Verfahren nach Patentanspruch 16 oder 18, **dadurch gekennzeichnet**, daß bei der Herstellung von kupferkaschierten Laminaten die der Verpressung vorgelagerten Imprägnier-und Trocknungsprozesse für die Materialbahnen (6) des Schichtstoffkerns auf dem rücklaufenden Trum (38) des Endlosbandes (34) durchgeführt werden.

22. Vorrichtung zur Durchführung des Verfahrens nach einem der Patentansprüche 1 bis 21 mit Abwickeleinheiten zur Aufnahme der Rollen (5) für die harzfreien Materialbahnen (6), einer Imprägniereinrichtung zur Tränkung der Materialbahnen (6) mit dem durch Wärme, chemische Reaktionen oder Kühlung härtbaren Harz, einer Einrichtung zur Vorhärtung des Harzes der Materialbahnen (6), einer Doppelbandpresse (1) zur Verpressung der Materialbahnen (6) zu einer Laminatbahn und einer Aufwickeleinrichtung mit einer Rolle zur Aufwicklung der Laminatbahn oder einer Querschneideeinheit zur Aufteilung der Laminatbahn in Platten, **dadurch gekennzeichnet**, daß wenigstens eine Harzauftragseinrichtung (11) für die Beharzung wenigstens einer Materialbahn (6) in der Nähe der Doppelbandpresse (1) zwischen der Auslaufzone (12) und der Einlaufzone (13) angeordnet ist und bei der Harzauftragseinrichtung (11) Mittel zur Führung der Materialbahn (6) vorhanden sind, so daß die Materialbahn (6) auf ein Bandtrum (38) des Preßbandes (34) aufgelegt wird, das von der Auslaufzone (12) zur Einlaufzone (13) in die Doppelbandpresse (1) zurückläuft.

23. Vorrichtung nach Patentanspruch 22, **dadurch gekennzeichnet,** daß die Harzauftragseinrichtung (11) in der Nähe der auslaufseitigen Umlenktrommel (31) der Doppelbandpresse (1) angeordnet ist.

24. Vorrichtung nach Patentanspruch 22 oder 23, **dadurch gekennzeichnet,** daß die Harzauftragseinrichtung (11) ein am Pressengestell der Doppelbandpresse (1) befestigtes kastenförmiges Gestell (51) besitzt, in dem eine Stützwalze (52) und eine Dosierwalze (54) drehbar gelagert sind, der zwischen der Stützwalze (52) und der Dosierwalze (54) gebildete Raum das zur Imprägnierung der Material bahnen (6) dienende Harz (55) enthält und die Material bahnen (6) mittels Umlenkwalzen (56) zwischen der Stützwalze (52) und der Dosierwalze (54) durch die Harzauftragseinrichtung (11) hindurchgeführt und auf das rücklaufende Bandtrum (38) des Preßbandes (34) aufgelegt werden.

## Claims

1. Method for the continuous production of laminates which consist of several layers of resin-impregnated material webs (6), which have been pressed together, wherein the resin-free material webs (6) are unreeled from rolls (5), impregnated by a resin (55), which is settable by heat, chemical reactions or cooling, thereafter dried with preliminary hardening of the resin (55) and guided together into a layer formation, this layer formation is subsequently introduced into a double band press (1) and pressed there under the influence of areal pressure, heat and/or cooling between two endless band (33, 34) into a laminate web and this laminate web is reeled into rolls or divided into plates after leaving the double band press (1), characterised thereby, that the impregnating and drying processes preceding the compression of at least one material web are performed at least in part on that run (38) of the endless band of the double band press (1), which runs from the outlet zone (12) of the double band press (1) back to the inlet zone (13) into the double band press (1) .

2. Method according to claim 1, characterised thereby that the impregnating and drying processes for all material webs (6) to be resined are performed on those runs of both the endless bands (33, 34) of the double band press (1), which run from the outlet zone (12) of the double band press (1) back to the inlet zone (13) into the double band press (1).

3. Method according to claim 1 or 2, characterized thereby, that the material web (6) is provided with resin and laid onto the returning run (38) of the endless band (34) between the deflecting drums (29, 30) at the inlet and outlet ends of the double band press (1) and the material web (6) is transported by the returning run (38) to the inlet zone (13) into the double band press (1).

4. Method according to claim 3, characterized thereby, that the material web (6) is provided with resin, laid onto the returning run (38) of the endless band (34) in the proximity of the outlet end deflecting drums (30, 31) in the double press (1) and transported by the returning run (38) of the endless band (34) to the inlet zone (13) into the double band press (1).

5. Method according to claim 1 or 2, characterized thereby, that the material web (6) is laid onto that run (38) of the endless band (34), which runs from the outlet zone (12) of the double band press (1) back to the inlet zone (13) into the double band press (1) and is subsequently provided with resin.

6. Method according to one of the claims 1 to 5, characterized thereby, that the returning run (38) of the endless band is heated.

7. Method according to one of the claims 1 to 6, characterized thereby, that a low-solvent resin is used for impregnation.

8. Method according to claim 7, characterized thereby, that a water-free resin is used for impregnation.

9. Method according to one of the claims 1 to 8, characterized thereby, that the resin is applied to the material web (6) superficially.

10. Method according to claim 9, characterized thereby, that the resin is applied as highly viscous liquid onto the surface of the material web (6).

11. Method according to claim 10, characterized thereby, that the resin is applied by means of a roller onto the surface of the material web (6).

12. Method according to claim 10, characterized thereby, that the resin is extruded onto the material web (6).

13. Method according to claim 9, characterized thereby, that the resin is applied as powder onto the surface of the material web (6).

14. Method according to claim 13, characterized thereby, that the powdery resin is applied onto the surface of the material web (6) by scattering or spraying.

15. Method according to one of the claims 1 to 14, characterized thereby, that the remaining solvent, which escapes from the resin during the drying process of the material web (6) on the endless band (34), is collected, removed by suction, cooled back and fed to the resin anew.

16. Method according to one of the claims 1 to 15, characterized thereby, that a thermosetting resin is used as resin for the impregnation of the material webs (6).

17. Method according to one of the claims 1 to 15, characterized thereby, that a thermoplastic resin is used as resin for the impregnation of the material webs (6).

18. Method according to claim 16, characterized thereby, that the temperature of the endless band (34) and its speed are so chosen that the material web (6) resting on the endless band (34) is fully impregnated on reaching the inlet zone (13) into the double band press (1) and the resin is hardened further to the B stage.

19. Method according to claim 16 or 18, characaterised thereby that for the production of decorative laminates, the impregnating and drying processes preceding the compression are performed on the returning run (38) of the endless band (34) for at least the heavy core paper.

20. Method according to claim 19, characterized thereby, that the impregnating and drying processes preceding the compression are likewise performed on the returning run (38) of the endless band (34) for the decorative paper web.

21. Method according to claim 16 or 19, characterized thereby, that for the production of copper-clad laminates, the impregnating and drying processes preceding the compression are performed on the returning run (38) of the endless band (34) for the material webs (6) of the laminate material core.

22. Apparatus for the performance of the method according to one of the claims 1 to 21, with unreeling units for the reception of the rolls (5) for the resin-free material webs (6), an impregnating equipment for the impregnation of the material webs (6) with the resin which is settable by heat, chemical reactions or cooling, an equipment for preliminary hardening of the resin of the material webs (6), a double-band press (1) for pressing the material webs (6) into a laminate web and a reeling equipment with a roll for the reeling of the laminate web or a transverse cutting unit for the division of the laminate web into plates characterized thereby, that at least one resin application equipment (11) is arranged for the resin coating of at least one material web (6) in the proximity of the double band press (1) between the outlet zone (12) and the inlet zone (13) and means for the guidance of the material web (6) are present at the resin application equipment (11) so that the material web (6) is laid onto a band run (38), which runs from the outlet zone (12) of the double band press (1) back to the inlet zone (13) into the double band press (1), of the press band (34).

23. Apparatus according to claim 22, characterized thereby, that the resin application equipment (11) is arranged in the proximity of the outlet end deflecting drum (31) of the double band press (1).

24. Apparatus according to claim 22 or 23, characterized thereby, that the resin application equipment (11) comprises a box-shaped frame (51), which is fastened at the press frame of the double band press (1) and in which a backing roll (52) and a metering roll (54) are borne to be rotatable, the space formed between the backing roll (52) and the metering roll (54) contains the resin (55) serving for the impregnation of the material webs (6) and the material webs (6) are guided through the resin application equipment (11) between the backing roll (52) and the metering roll (54) by means of deflecting rolls (56) and laid onto the returning band run (38) of the press band (34).

## Revendications

1. Procédé de production en continu de stratifiés qui sont constitués de plusieurs couches de bandes de matériaux (6) comprimés imprégnés de résine, où les bandes de matériau sans résine (6) sont déroulées depuis des bobines (5) on les imprègne d'une résine (55) durcissable par la chaleur, des réactions chimiques au refroidissement, on sèche après prédurcissement de la résine (55) et on assemble en une structure feuilletée, on introduit cette structure feuilletée ensuite dans une presse à double bande (1) et sous l'effet de la pression superficielle, de la chaleur et/ou du refroidissement on comprime entre deux bandes sans fin (33, 34) en bande de stratifié et on enroule cette bande de stratifié après avoir quitté la presse à double bande (1) en bobines ou on découpe en plaques, caractérisé en ce que les procédés d'imprégnation et de séchage placés en amont de la compression sont réalisés pour au moins une bande de matériau en partie sur la toile (38) de la bande sans fin de la presse à double bande (1) qui retourne de la zone de sortie (12) de la presse à double bande (1) vers la zone d'entrée (13) de la presse à double bande (1).

2. Procédé selon la revendication 1, caractérisé en ce qu'on réalise les processus d'imprégnation et de séchage pour toutes les bandes de matériau (6) à imprégner de résine sur la toile des deux bandes sans fin (33, 34) de la presse à double bande (1), qui retournent de la zone de sortie (12) de la presse à double bande (1) vers la zone d'entrée (13) de la presse à double bande (1).

3. Procédé selon la revendication 1 ou 2, caractérisé en ce qu'on apporte de la résine à la bande de matériau (6) et qu'on place cette bande entre les tambours de renvoi d'entrée et de sortie (29, 30) de la presse à double bande (1) sur la toile en retour (31) de la bande de matériau (6) avec la toile en retour (30) vers la zone d'entrée (13) dans la presse à double bande (1).

4. Procédé selon la revendication 3, caractérisé en ce que la feuille de matériau (6) est munie de résine, elle est déposée à proximité du tambour de renvoi côté sortie (30, 31) de la presse à double bande (1) sur la toile en retour (38) de la bande sans fin (34) et la bande de matériau (6) est transférée avec la toile en retour (38) vers la zone d'entrée (13) dans la presse à double bande (1).

5. Procédé selon la revendication 1 ou 2, caractérisé en ce que la bande de matériau (6) est déposée sur la toile (38) en retour de la bande sans fin (34) de la presse à double bande (1) à la zone d'entrée (13) de la presse à double bande (1) et ensuite on la munit de résine.

6. Procédé selon l'une des revendications 1 à 5, caractérisé en ce qu'on chauffe la toile (38) en retour de la bande sans fin.

7. Procédé selon l'une des revendications 1 à 6, caractérisé en ce que pour l'imprégnation on utilise une résine pauvre en solvant.

8. Procédé selon la revendication 7, caractérisé en ce qu'on utilise pour l'imprégnation une résine exempte d'eau.

9. Procédé selon l'une des revendications 1 à 8, caractérisé en ce qu'on dépose la résine en surface sur la bande de matériau (6).

10. Procédé selon la revendication 9, caractérisé en ce qu'on dépose la résine sous forme de liquide très visqueux à la surface de la bande de matériau (6).

11. Procédé selon la revendication 10, caractérisé en ce qu'on dépose la résine au moyen d'un cylindre à la surface de la bande de matériau (6).

12. Procédé selon la revendication 10, caractérisé en ce qu'on extrude la résine sur la bande de matériau (6).

13. Procédé selon la revendication 9, caractérisé en ce qu'on dépose la résine sous forme de poudre à la surface de la bande de matériau (6).

14. Procédé selon la revendication 13, caractérisé en ce qu'on dépose la résine en poudre par pulvérisation ou épandage à la surface de la bande de matériau (6).

15. Procédé selon l'une des revendications 1 à 14, caractérisé en ce qu'on recueille, aspire, refroidit et recycle dans la résine le solvant résiduel qui s'échappe de la résine pendant le processus de séchage de la bande de matériau (6) sur la bande sans fin (34).

16. Procédé selon l'une des revendications 1 à 15, caractérisé en ce qu'on utilise comme résine d'imprégnation des bandes de matériau (6) une résine thermodurcissable.

17. Procédé selon l'une des revendications 1 à 15, caractérisé en ce qu'on utilise comme résine d'imprégnation des bandes de matériau (6) une résine thermoplastique.

18. Procédé selon la revendication 16, caractérisé en ce qu'on choisit la température de la bande sans fin (34) et sa vitesse de sortes que la bande de matériau (6) reposant sur la bande sans fin (34) est totalement imprégnée quand elle atteint la zone d'entrée (13) dans la presse à double bande (1) et que la résine est durcie à l'état B.

19. Procédé selon la revendication 16 ou 18, caractérisé en ce que lors de la production de stratifiés décorés on fait passer au moins le papier de coeur lourd sur la toile (38) de la bande sans fin (34) dans les processus d'imprégnation et de séchage en amont de la compression.

20. Procédé selon la revendication 19, caractérisé en ce qu'on réalise les processus d'imprégnation et de séchage en amont de la compression pour la bande de papier décorée en amont de la compression sur la toile (38) en retour de la bande sans fin (34).

21. Procédé selon la revendication 16 ou 18, caractérisé en ce que lors de la production de stratifiés doublés de cuivre on réalise les processus d'imprégnation et de séchage en amont de la compression pour les feuilles de matériau (6) du noyau de substance feuilletée sur la toile en retour (38) de la bande sans fin (34).

22. Dispositif de réalisation du procédé selon l'une des revendications 1 à 21 avec des unités de déroulement pour recevoir les bobines (5) de bande (6) de matériau sans résine un dispositif d'imprégnation pour imprégner les bandes de matériau (6) avec la résine durcissable par la chaleur, des réactions chimiques ou le refroidissement, un dispositif de prédurcissement de la résine des bandes de matériau (6), une presse à double bande (1) pour comprimer les bandes de matériau (6) en une bande stratifiée et un dispositif d'enroulement avec une bobine pour enrouler la bande de stratifié ou une unité de découpe pour couper la bande de stratifié en plaques, caractérisé en ce qu'il existe au moins un dispositif de dépôt de résine (11) pour imprégner de résine au moins une bande de matériau (6) à proximité de la presse à double bande (1) entre la zone de sortie (12) et la zone d'entrée (13) et que dans le dispositif de dépôt de résine (11) il existe des moyens de guidage de la bande de matériau (6) de façon à déposer la bande de matériau (6) sur une toile de bande (38) de la bande de pressage (34), qui circule en sens rétrograde de la zone de sortie (12) vers la zone d'entrée (13) de la presse à double bande (1).

23. Dispositif selon la revendication 22, caractérisé en ce que le dispositif de dépôt de résine (11) est implanté à proximité du tambour de renvoi (31) du côté sortie de la presse à double bande (1).

24. Dispositif selon la revendication 22 ou 23, caractérisé en ce que le dispositif de dépôt de résine (11) possède un châssis (51) en forme de caisse fixé sur le châssis de la presse à double bande (1) où sont logés en rotation un cylindre d'appui (52) et un cylindre doseur (54), le volume compris entre le cylindre d'appui (52) et le cylindre doseur (54) contient la résine (55) servant à imprégner les bandes de matériau (6) et les bandes de matériau (6) sont guidées par les cylindres de renvoi (56) entre le cylindre d'appui (52) et le cylindre doseur (54) dans le dispositif de dépôt de résine (11) et déposées sur la toile de bande (38) en retour de la bande de pressage (34).
